# EUROPÄISCHE PATENTSCHRIFT

(11) **EP 2 859 598 B1**
(45) Veröffentlichungstag und Bekanntmachung des Hinweises auf die Patenterteilung: **21.03.2018**
(21) Anmeldenummer: 13726479.2
(22) Anmeldetag: 24.05.2013
(51) Int. Cl.: H01L 35/30, H01L 35/32

(54) **THERMOELEKTRISCHES MODUL UND VERFAHREN ZUM BETRIEB**
THERMOELECTRIC MODULE AND METHOD FOR OPERATING SAME
MODULE THERMOÉLECTRIQUE ET PROCÉDÉ POUR LE FAIRE FONCTIONNER

(30) Priorität: 06.06.2012 DE 102012104927
(43) Veröffentlichungstag der Anmeldung: 15.04.2015
(73) Patentinhaber: Continental Automotive GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2013/060765
(87) Internationale Veröffentlichungsnummer: WO 2013/182441

(56) Entgegenhaltungen:
- US-A- 3 607 444
- US-A1- 2012 018 835

## Beschreibung

Die vorliegende Erfindung betrifft ein thermoelektrisches Modul und ein Verfahren zum Betrieb eines thermoelektrischen Moduls.

Thermoelektrische Module können einzeln oder in einer Mehrzahl als thermoelektrischer Generator eingesetzt werden, der aus einem Temperaturpotential und dem daraus resultierenden Wärmestrom elektrische Energie erzeugt. Die Erzeugung der elektrischen Energie erfolgt aufgrund des sogenannten Seebeck-Effekts. Thermoelektrische Module sind aus elektrisch miteinander verschalteten p-dotierten und n-dotierten thermoelektrischen Materialien aufgebaut. Die thermoelektrischen Materialien weisen eine sogenannte Heißseite und eine gegenüberliegend angeordnete Kaltseite auf, über die sie jeweils elektrisch leitend wechselweise mit benachbart angeordneten weiteren thermoelektrischen Materialien verbunden sind. Die Heißseite ist dabei mit einer Wandung eines thermoelektrischen Moduls wärmeleitend verbunden, die mit einem heißen Medium beaufschlagt wird. Entsprechend ist die Kaltseite des thermoelektrischen Materials mit einer anderen Wandung des thermoelektrischen Moduls in wärmeleitender Verbindung, die mit einem kalten Medium beaufschlagt ist.

Derartige thermoelektrische Generatoren kommen insbesondere in Kraftfahrzeugen zum Einsatz, aber auch in anderen technischen Gebieten, in denen ein Temperaturpotential durch die Anordnung von thermoelektrischen Generatoren zur Erzeugung elektrischer Energie ausgenutzt werden kann.

Bei dem Einsatz von thermoelektrischen Generatoren wird häufig ein Abfall der Effizienz hinsichtlich der Umwandlung von thermischer Energie in elektrische Energie über die Laufzeit des thermoelektrischen Generators beobachtet. Diese, während des Betriebs auftretende Verschleißerscheinung, kann insbesondere darauf zurückgeführt werden, dass sich die Verbindungen zwischen thermoelektrischem Material und weiteren Verbindungsschichten hin zu einer ersten Wandung und/oder zu einer zweiten Wandung eines thermoelektrischen Moduls zunehmend verschlechtern. Diese Beeinträchtigungen der wärmeleitenden und/oder elektrisch leitenden Verbindungen werden insbesondere dadurch hervorgerufen, dass das thermoelektrische Modul regelmäßig wechselnden oder variierenden Temperaturen und Temperaturpotentialen ausgesetzt wird. Das thermoelektrische Modul wird entsprechend durch wechselnde Wärmeausdehnungen und resultierende Wärmespannungen belastet. Zudem verstärken unterschiedliche Wärmeausdehnungskoeffizienten in den einzelnen Verbindungsschichten diese Beanspruchungen.

Die US 2012/018835 A1 betrifft ein thermoelektrisches Modul, bei dem infolge eines Temperaturwechsels auftretende Spannungen kompensiert werden können. Dies wird durch thermoelektrische Elemente erreicht, die an einem Ende (z. B. Kaltseite) eine geneigte Oberseite aufweisen, wobei die geneigte Oberseite mit einer entsprechend geformten Fläche eines elektrischen Leiters verbunden ist. Die thermoelektrischen Elemente werden durch eine seitliche Federeinrichtung verspannt und gleiten auf der geneigten Oberfläche ab. Damit werden auch bei Längenänderungen der thermoelektrischen Elemente der Wärmeübergang und die elektrische Kontaktierung im thermoelektrischen Modul sichergestellt.

Aufgabe der vorliegenden Erfindung ist es demnach, die mit Bezug auf den Stand der Technik geschilderten Probleme zumindest teilweise zu lösen. Insbesondere soll ein thermoelektrisches Modul angegeben werden, das eine gleichmäßige hohe Effizienz bei der Umwandlung von thermischer Energie in elektrische Energie über eine lange Laufzeit aufweist. Darüber hinaus soll ein Verfahren zum Betrieb eines thermoelektrischen Moduls angegeben werden, das ebenfalls eine verlängerte Laufzeit eines thermoelektrischen Moduls ermöglicht, ohne dass die Effizienz in zunehmendem Maße verringert wird.

Diese Aufgaben werden gelöst mit einem thermoelektrischen Modul gemäß den Merkmalen des Patentanspruchs 1 oder des Patentanspruchs 2 und durch ein Verfahren zum Betrieb eines thermoelektrischen Moduls gemäß Patentanspruch 7. Vorteilhafte Ausgestaltungen der Erfindung sind in den abhängig formulierten Patentansprüchen angegeben. Es ist darauf hinzuweisen, dass die in den Patentansprüchen einzeln aufgeführten Merkmale in beliebiger, technologisch sinnvoller Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an. Es ist weiter darauf hinzuweisen, dass die in Bezug auf das thermoelektrische Modul beschriebenen Ausgestaltungen gleichermaßen in technisch sinnvoller Weise auf das Verfahren zum Betrieb eines thermoelektrischen Moduls anwendbar sind und umgekehrt.

Das erfindungsgemäße thermoelektrische Modul weist zumindest eine erste Wandung und eine gegenüberliegend angeordnete zweite Wandung sowie dazwischen angeordnete Elemente aus thermoelektrischem Material auf, die elektrisch leitend miteinander verbunden sind. Weiter ist ein Füllmaterial vorgesehen, durch das alle Elemente voneinander beabstandet sind. Eine Hauptwärmestromrichtung verläuft dabei von einer, durch die erste Wandung gebildeten Heißseite hin zur zweiten Wandung. Es ist vorgesehen, dass im Betrieb des thermoelektrischen Moduls, zumindest in einem Temperaturbereich zwischen 50 und 600 °C [Grad Celsius] an der Heißseite, eine auf die Elemente in Hauptwärmestromrichtung einwirkende zweite Druckspannung zumindest eine erste Grenzspannung nicht überschreitet oder zumindest eine zweite Grenzspannung nicht überschreitet. Die erste Grenzspannung ist eine (temperaturabhängige) Eigenschaft der Elemente aus thermoelektrischem Material, bei deren Überschreitung eine Querkontraktion des eingesetzten thermoelektrischen Materials einsetzt. Die zweite Grenzspannung ist eine (temperaturabhängige) Eigenschaft der Elemente aus thermoelektrischem Material, bei deren Überschreitung eine plastische Verformung des eingesetzten thermoelektrischen Materials einsetzt.

Insbesondere gilt, dass wenn die zweite Grenzspannung erreicht wird, bereits eine Querkontraktion des thermoelektrischen Materials eingesetzt hat.

Das weitere erfindungsgemäße thermoelektrische Modul weist zumindest eine erste Wandung und eine gegenüberliegend angeordnete zweite Wandung sowie dazwischen angeordnete Elemente aus thermoelektrischem Material auf, wobei die thermoelektrischen Materialien elektrisch leitend miteinander verbunden sind. Weiterhin ist ein Füllmaterial vorgesehen, durch das alle Elemente voneinander beabstandet sind. Eine Hauptwärmestromrichtung verläuft ausgehend von der ersten Wandung hin zur zweiten Wandung. Das thermoelektrische Modul ist derart durch zumindest eine Druckkraft verspannt, dass eine erste Druckspannung quer zur Hauptwärmestromrichtung, zumindest in einem Bereich, in dem ein Temperaturpotential zwischen erster Wandung und zweiter Wandung mindestens 50 Kelvin, insbesondere mindestens 200 Kelvin beträgt, mindestens 50 % einer zweiten Druckspannung in Hauptwärmestromrichtung beträgt, insbesondere mindestens 75 %, und bevorzugt mindestens so groß ist wie die zweite Druckspannung (größer 100 %). Insbesondere wirkt die erste Druckspannung (und bevorzugt auch die zweite Druckspannung) dabei auf eine Mehrheit, bevorzugt auf alle, Elemente innerhalb des thermoelektrischen Moduls.

Die vorgenannten erfindungsgemäßen Merkmale können auch mit einander kombiniert vorliegen.

Die vorliegende Erfindung ist auf verschiedene Ausführungen von thermoelektrischen Modulen anwendbar. Hierbei sind insbesondere rohrförmig aufgebaute thermoelektrische Module oder plattenförmig aufgebaute thermoelektrische Module zu nennen, wobei in den rohrförmigen thermoelektrischen Modulen z. B. ringförmige thermoelektrische Materialien eingesetzt werden.

Insbesondere ist die erste Wandung einer Heißseite des thermoelektrischen Moduls zugeordnet, die also von einem heißen Medium (z. B. Abgas) beaufschlagt wird. Entsprechend ist die zweite Wandung des thermoelektrischen Moduls einer Kaltseite zugeordnet, die von einem kalten Medium (z. B. Kühlwasser) beaufschlagt wird. Zwischen heißem Medium und kaltem Medium liegt im Betrieb regelmäßig ein Temperaturpotential vor, insbesondere in einem Bereich von 50 K [Kelvin] bis 600 K. Zwischen erster Wandung und zweiter Wandung sind Elemente aus thermoelektrischem Material angeordnet, wobei die thermoelektrischen Materialien zwei gegenüberliegende Seiten aufweisen, die entsprechend der Heißseite oder der Kaltseite zugewandt sind, so dass sich über das thermoelektrische Material ein Temperaturpotential ausbildet und entsprechend eine Hauptwärmestromrichtung von Heißseite zur Kaltseite bildet. Infolge des Seebeck-Effekts wird aus diesem Temperaturpotential und durch die wechselweise elektrisch leitende Verbindung der n-dotierten und p-dotierten thermoelektrischen Materialien ein elektrischer Strom innerhalb des thermoelektrischen Moduls erzeugt. Der grundsätzliche Aufbau der elektrischen Verschaltung solcher Elemente aus thermoelektrischem Material ist dem Fachmann bekannt, gegebenenfalls können weitere Informationen hierzu aus den Vorveröffentlichungen der Anmelderin entnommen werden.

Das Füllmaterial zwischen den thermoelektrischen Elementen dient einerseits insbesondere der elektrischen Isolierung der benachbart zueinander angeordneten thermoelektrischen Materialien und/oder andererseits zur thermischen Isolierung zwischen Heißseite und Kaltseite, so dass ein Großteil des Wärmestroms über die thermoelektrischen Elemente geführt wird. Damit ist eine effiziente Umwandlung der Wärmeenergie aus dem vorliegenden Temperaturpotential in elektrische Energie möglich.

Andererseits ist das Füllmaterial insbesondere dazu vorgesehen, die benachbart zueinander angeordneten thermoelektrischen Materialien voneinander zu beabstanden oder mit anderen Worten auch während allen Betriebsbedingungen auf eine (vorgegebene) Distanz zu halten. Insbesondere ist das Füllmaterial also nicht durch Luft oder ein Vakuum gebildet, sondern durch wenigstens einen Festkörper, der die Position der thermoelektrischen Materialien zueinander dauerhaft fixiert. Zwischen den thermoelektrischen Materialien und der ersten Wandung und/oder der zweiten Wandung und/oder auch zwischen thermoelektrischen Materialien und dem Füllmaterial können weitere Komponenten oder Verbindungsschichten angeordnet sein, die spezifische Aufgaben erfüllen, wie beispielsweise Vermeidung von Korrosion, Erzeugen einer festen (z. B. stoffschlüssigen) Verbindung, Bereitstellen einer elektrischen Leitschicht, Bereitstellen einer wärmeleitenden Schicht, elektrische Isolierung und/oder thermische Isolierung.

Als Füllmaterial kann insbesondere Glimmer oder eine druckfeste Keramik eingesetzt werden. Bevorzugt wird die Keramik als keramischer Hohlkörper eingesetzt. Weiterhin kann das Füllmaterial in der Form eines Doppel-T-Profils eingesetzt werden. Bevorzugt wird das Füllmaterial in Gestalt einer formsteifen Konstruktion eingesetzt, insbesondere in Form einer Fachwerk-artigen Konstruktion. Die darin vorgesehenen Hohlräume sind insbesondere mit Luft, Gas oder Vakuum ausgefüllt.

Es wurde nun beobachtet, dass das thermoelektrische Material durch die thermische Beanspruchung infolge des vorliegenden Temperaturpotentials und insbesondere durch die damit verbundenen thermischen Spannungen eine verstärkte Neigung zur Querkontraktion und/oder eine Kriechneigung hat bzw. zu einer plastischen Verformung neigt, die jeweils zu einer Verschlechterung der Verbindung zwischen thermoelektrischem Material und weiteren Verbindungsschichten führt, insbesondere hin zu der ersten Wandung bzw. hin zu der zweiten Wandung. Diese thermischen Spannungen werden insbesondere auch durch Anordnung der thermoelektrischen Materialien in einem weitgehend formstabilen thermoelektrischen Modul hervorgerufen, so dass sich die thermoelektrischen Materialien nur unter Spannung ausdehnen können.

Diese Kriechneigung/ plastische Verformung kann nun insbesondere dadurch reduziert bzw. verhindert werden, dass das thermoelektrische Modul derart aufgebaut ist, dass zumindest in einem Temperaturbereich zwischen 50 °C und 600 °C [Grad Celsius] an der Heißseite, eine auf die Elemente in Hauptwärmestromrichtung einwirkende zweite Druckspannung eine zweite Grenzspannung nicht überschreitet. Eine zweite Grenzspannung ist die auf die thermoelektrischen Materialien einwirkende Spannung, bei der eine plastische Verformung des eingesetzten thermoelektrischen Materials einsetzt.

Die Querkontraktion des thermoelektrischen Materials kann insbesondere dadurch reduziert bzw. verhindert werden, dass das thermoelektrische Modul derart aufgebaut ist, dass zumindest in einem Temperaturbereich zwischen 50 °C und 600 °C [Grad Celsius] an der Heißseite, eine auf die Elemente in Hauptwärmestromrichtung einwirkende zweite Druckspannung eine erste Grenzspannung nicht überschreitet. Eine erste Grenzspannung ist die auf die thermoelektrischen Materialien einwirkende Spannung, bei der bereits eine elastische Verformung des eingesetzten thermoelektrischen Materials einsetzt.

Die Querkontraktion ist ein Phänomen der Deformation eines festen Körpers bei annähernd gleichbleibendem Volumen. Sie beschreibt das Verhalten des Festkörpers unter dem Einfluss einer Zugkraft bzw. Druckkraft (hier einer zweiten Druckspannung). In Richtung der Kraft (hier die zweite Druckspannung) reagiert der Körper mit einer Längenänderung (hier Verkürzung in Hauptwärmestromrichtung), senkrecht dazu (in Richtung quer zur Hauptwärmestromrichtung) mit einer Verringerung bzw. Vergrößerung seines Durchmessers oder seiner Dicke (hier Ausdehnung, also Vergrößerung der Dicke des thermoelektrischen Materials). Die Längenänderung bei einachsigem Zug kann im linear-elastischen Bereich durch das vereinfachte Hookesche Gesetz bestimmt werden. Über die Dickenänderung macht das Hookesche Gesetz in seiner vereinfachten Form jedoch keine Aussagen.

Insbesondere ist die erste Grenzspannung (deutlich) geringer als die zweite Grenzspannung.

Für einen solchen Aufbau ist insbesondere das Material für die erste Wandung und/oder die zweite Wandung auf das thermoelektrische Material und/oder das Füllmaterial hinsichtlich Wärmeausdehnung, Wärmeleitung, Festigkeit entsprechend aufeinander abzustimmen. Insbesondere ist ggf. zusätzlich die konstruktive Gestaltung des Aufbaus des thermoelektrischen Moduls anzupassen. Beispielsweise können Dehnelemente vorgesehen sein, die eine elastische Verformung der ersten Wandung und/oder der zweiten Wandung ermöglichen, so dass die auf die Elemente wirkende (zweite) Druckspannung minimiert wird.

Die erste und die zweite Grenzspannung sind jeweils insbesondere spezifisch für das eingesetzte thermoelektrische Material und insbesondere abhängig zumindest von der Temperatur des thermoelektrischen Materials. Weiterhin sind die erste und zweite Grenzspannung abhängig von der auf das thermoelektrische Material einwirkenden Spannung, die der Richtung der Ausdehnung (im Fall der ersten/ zweiten Grenzspannung) oder der Richtung der Kriechneigung (im Fall der zweiten Grenzspannung) des thermoelektrischen Materials entgegengesetzt ist. Insbesondere heißt das, dass die erste und zweite Grenzspannung des thermoelektrischen Materials beeinflusst (erhöht) werden können, wenn die auf die thermoelektrischen Materialien wirkende erste Druckspannung erhöht wird. Dies erfolgt insbesondere selbstregulierend, z. B. dadurch, dass sich die Füllmaterialien zwischen den thermoelektrischen Materialien bei Erwärmung stärker in Richtung quer zur Hauptwärmestromrichtung ausdehnen als das thermoelektrische Modul insgesamt.

Die unten genannten thermoelektrischen Materialien weisen bei den genannten Temperaturen und ohne weitere Druckbeanspruchung (z. B. zusätzlich durch erste Druckspannung) die folgenden zweiten Grenzspannungen auf, bei deren Überschreitung mit einer plastischen Verformung zu rechnen ist:

| | |
|---|---|
| Pb₂Te₃ (n-dotiert): | 100 N/mm² bei Raumtemperatur 40 N/mm² bei 300°C |
| Pb₂Te₃ (p-dotiert): | keine plastische Verformung bis 300°C |
| BiTe (n-dotiert oder p-dotiert): | 110 N/mm² bei Raumtemperatur 30 N/mm² bei 250°C |
| CoSb₄ (n-dotiert oder p-dotiert): | keine plastische Verformung bis 300°C 300 N/mm² bei 500°C |

Gemäß einer weiteren Ausgestaltung des thermoelektrischen Moduls kann die Querkontraktion und/oder die Kriechneigung/ plastische Verformung dadurch reduziert bzw. verhindert werden, dass das thermoelektrische Modul mit zumindest einer Druckkraft beaufschlagt wird, so dass eine erste Druckspannung quer zur Hauptwärmestromrichtung auf die Elemente einwirkt, wobei hier bevorzugt ist, möglichst eine große Anzahl oder sogar alle Elemente mit dieser Druckkraft zu beaufschlagen. Dies erfolgt zumindest in einem Bereich, in dem das genannte Temperaturpotential vorliegt, so dass diese erste Druckspannung dann mindestens 50 % einer zweiten Druckspannung in Hauptwärmestromrichtung beträgt.

Die zweite Druckspannung wird insbesondere durch die spaltfreie Anordnung der thermoelektrischen Materialien in einer Richtung von der ersten Wandung hin zu der zweiten Wandung hervorgerufen, also in Hauptwärmestromrichtung. Infolge des Temperaturpotentials kommt es zu einer Wärmeausdehnung der zwischen erster Wandung und zweiter Wandung angeordneten Komponenten des thermoelektrischen Moduls, so dass eine zweite Druckspannung in Hauptwärmestromrichtung entsteht bzw. erhöht wird. Diese zweite Druckspannung wirkt der Wärmeausdehnung der einzelnen Komponenten in Hauptwärmestromrichtung entgegen und führt insbesondere bei dem thermoelektrischen Material zu einer Ausdehnung (durch Querkontraktion) und/ oder zu einer Kriechneigung in einer Richtung quer zur Hauptwärmestromrichtung. Die Querkontraktion und/ oder die Kriechneigung kann überraschend durch Aufbringen zumindest einer ersten Druckspannung quer zur Hauptwärmestromrichtung verringert bzw. vollständig unterbunden werden. Insbesondere sind entsprechend weitere erste Druckspannungen vorzusehen, so dass in alle Richtungen quer zur Hauptwärmestromrichtung diese Querkontraktion und/ oder diese Kriechneigung verringert bzw. vollständig unterbunden wird. Damit wurde auch erstmalig erkannt, dass entgegen der üblichen Ansicht, thermische Ausdehnung mit Wegkompensationsmitteln zu erlauben, beim thermoelektrischen Modul eine Art Druckrahmen für die Elemente zu einer verbesserten Effizienz über die Laufzeit führt.

Eine vorteilhafte Ausgestaltung des thermoelektrischen Moduls ist darauf gerichtet, dass das Füllmaterial zumindest in einem Temperaturbereich von 50 °C bis 600 °C einen größeren thermischen Ausdehnungskoeffizienten aufweist als das thermoelektrische Material. Das Füllmaterial ist zumindest in einer Richtung quer zur Hauptwärmestromrichtung so zwischen den thermoelektrischen Materialien angeordnet, dass sich die thermoelektrischen Materialien über das Füllmaterial (und ggf. über weitere Komponenten oder Verbindungsschichten) gegeneinander abstützen, also insbesondere spaltfrei in dieser Richtung zueinander angeordnet sind. Das Füllmaterial fixiert somit die thermoelektrischen Materialien in ihrer jeweiligen Position zueinander. Durch die Gestaltung des Füllmaterials mit einem größeren thermischen Ausdehnungskoeffizienten als das thermoelektrische Material kann, bei Aufheizung des Füllmaterials und der weiteren Komponenten im thermoelektrischen Modul, eine Druckkraft bzw. eine Druckspannung in einer Richtung quer zur Hauptwärmestromrichtung (erst während des Betriebes) erzeugt oder (signifikant) vergrößert werden. Insbesondere ist dafür eine weitgehend formstabile Auslegung des thermoelektrischen Moduls in dieser Richtung quer zur Hauptwärmestromrichtung sicherzustellen. Die Druckkraft muss dann nicht von außen auf das thermoelektrische Modul so aufgebracht werden, dass die Druckspannung sich entsprechend innerhalb des thermoelektrischen Moduls ausbildet, so dass die meisten (oder alle) Elemente durch eine ausreichende Druckspannung beaufschlagt werden. Stattdessen kann diese Druckspannung so zwischen den meisten (oder allen) Elementen durch das Füllmaterial in Wechselwirkung mit den thermoelektrischen Materialien erzeugt werden.

Eine weitere vorteilhafte Ausgestaltung des thermoelektrischen Moduls ist darauf gerichtet, dass das Füllmaterial zumindest in einem Temperaturbereich von 50 °C bis 600 °C eine geringere Wärmeleitfähigkeit [Watt / (Meter * Kelvin] aufweist als das thermoelektrische Material. Insbesondere beträgt der Wert der Wärmeleitfähigkeit des Füllmaterials höchstens 10 % des Wertes des thermoelektrischen Materials, bevorzugt höchstens 1 %.

Eine weitere vorteilhafte Ausgestaltung des thermoelektrischen Moduls sieht vor, dass das Füllmaterial, betrachtet zumindest in einer Richtung parallel zur Hauptwärmestromrichtung, einen Zwischenraum zwischen erster Wandung und zweiter Wandung nicht vollständig ausfüllt. Es ist insbesondere vorteilhaft, dass das Füllmaterial die Position der thermoelektrischen Materialien zueinander fixiert, gleichzeitig aber nicht die gesamte Seitenfläche der thermoelektrischen Materialien, die jeweils den benachbart angeordneten thermoelektrischen Materialien zugewandt ist, bedeckt. Insbesondere werden höchstens 80 %, bevorzugt höchstens 50 % und besonders bevorzugt höchstens 20 % dieser Seitenfläche durch das Füllmaterial mit einer Druckspannung beaufschlagt, wobei das nicht für alle Elemente bzw. thermoelektrischen Materialen eines einzelnen Moduls gleichermaßen gelten muss. Über das Füllmaterial wird die Druckkraft bzw. die Druckspannung auf das thermoelektrische Material übertragen. Durch die entsprechende Anordnung des Füllmaterials kann insbesondere die thermische Isolierung zwischen erster Wandung und zweiter Wandung in besonders vorteilhafter Weise umgesetzt werden und das Füllmaterial muss diese thermische isolierende Eigenschaft nicht zwingend erfüllen. Beispielsweise kann Luft, ein Vakuum oder ein anderer wärmeisolierender Werkstoff zusätzlich zum Füllmaterial eingesetzt werden.

Eine vorteilhafte Weiterbildung des thermoelektrischen Moduls ist darauf gerichtet, dass auf einer Kaltseite eine Verspannungsvorrichtung zur Erzeugung der Druckkraft auf das thermoelektrische Modul in einer Richtung quer zur Hauptwärmestromrichtung angeordnet ist. Insbesondere umfasst diese Anordnung eine z. B. mit der zweiten Wandung verbundene Verspannungsvorrichtung. Diese Verspannungsvorrichtung wird insbesondere thermisch isoliert gegenüber der ersten Wandung ausgeführt. Dadurch weist die Verspannungsvorrichtung eine geringe Wärmedehnung trotz des vorliegenden Temperaturpotentials auf und kann die Formstabilität des thermoelektrischen Moduls in einer Richtung quer zur Hauptwärmestromrichtung über den betrachteten Temperaturbereich gewährleisten. Die Verspannungsvorrichtung kann insbesondere eine mechanische oder auch hydraulische Vorrichtung sein. Insbesondere wird sie durch eine besonders formsteife Ausgestaltung der Kaltseite bzw. der zweiten Wandung gebildet, so dass in dem betrachteten Temperaturbereich eine (im Wesentlichen gleichbleibende oder angepasste) Druckkraft gegenüber den thermoelektrischen Materialien und dem Füllmaterial ausgehend von der Verspannungsvorrichtung erzeugt werden kann.

Insbesondere ist eine Verspannungsvorrichtung an der ersten Wandung (Heißseite) (zusätzlich) vorgesehen.

Die Verspannungsvorrichtung kann insbesondere ein elastisch verformbares Element umfassen, das mit stärkerer Verformung eine entsprechend höhere Druckspannung in das thermoelektrische Modul einleiten kann. Beispielsweise kann eine Druckfeder vorgesehen sein, die bei fortlaufender Ausdehnung des thermoelektrischen Moduls, bzw. bei Ausdehnung der Elemente in einer Richtung quer zur Hauptwärmestromrichtung eine entsprechend steigende Druckspannung erzeugt. Durch diese steigende Druckspannung wird eine elastische Ausdehung und/ oder eine plastische Verformung der thermoelektrischen Materialien in einer Richtung quer zur Hauptwärmestromrichtung verringert oder verhindert.

Die Erfindung ist weiterhin auf ein Verfahren zum Betrieb eines thermoelektrischen Moduls gerichtet, wobei das thermoelektrische Modul eine erste Wandung und eine zweite Wandung und dazwischen angeordnete Elemente aus thermoelektrischem Material aufweist, die elektrisch leitend miteinander verbunden sind. Im Betrieb des thermoelektrischen Moduls liegt ein Temperaturpotential zwischen erster Wandung und zweiter Wandung vor und entsprechend verläuft eine Hauptwärmestromrichtung von der ersten Wandung hin zu der zweiten Wandung. Das Verfahren zum Betrieb weist zumindest folgende Schritte auf:
a) Erzeugen eines Temperaturpotentials zwischen erster Wandung und zweiter Wandung;
b) Aufbringen mindestens einer Druckkraft zur Erzeugung einer ersten Druckspannung quer zur Hauptwärmestromrichtung, wobei die Druckspannung zumindest auf eine Mehrheit der Elemente einwirkt;
c) Sicherstellen, dass zumindest in einem Betriebsbereich, in dem ein Temperaturpotential zwischen erster Wandung und zweiter Wandung mindestens 50 Kelvin beträgt, die erste Druckspannung mindestens 50 % einer zweiten Druckspannung in Hauptwärmestromrichtung beträgt, insbesondere mindestens 75 % und bevorzugt mindestens so groß ist wie eine zweite Druckspannung in Hauptwärmestromrichtung.

Die Ausführungen zum jeweiligen thermoelektrischen Modul gelten entsprechend für das Verfahren zum Betrieb eines thermoelektrischen Moduls und umgekehrt. Insbesondere ist das hier erfindungsgemäß beschriebene Verfahren zum Betrieb des jeweils erfindungsgemäßen thermoelektrischen Moduls geeignet.

Das Erzeugen des Temperaturpotentials gemäß Schritt a) umfasst das Beaufschlagen der ersten Wandung mit einem heißen Medium und das Beaufschlagen der zweiten Wandung mit einem kalten Medium. Insbesondere sind ein Abgas oder ein flüssiges Medium als heißes Medium und z. B. Wasser oder eine ähnliche Flüssigkeit, aber auch ein gasförmiges Medium als kaltes Medium vorzusehen.

Schritt b) umfasst das Aufbringen mindestens einer Druckkraft, die insbesondere durch eine Verspannungsvorrichtung von außen auf das thermoelektrische Modul aufgebracht und/oder auch innerhalb des thermoelektrischen Moduls z. B. durch entsprechende Ausdehnungskoeffizienten des thermoelektrischen Materials und des Füllmaterials erzeugt werden kann.

Das Sicherstellen des Verhältnisses der Druckspannungen gemäß Schritt c) umfasst insbesondere die entsprechende konstruktive Auslegung des thermoelektrischen Moduls bereits vor der Aufnahme des Betriebs. Insbesondere umfasst das Sicherstellen die Kontrolle und entsprechende Einwirkung, so dass die erste und/oder zweite Druckspannung berechnet, gemessen oder in anderer Weise bestimmt und eine entsprechende erste Druckspannung erzeugt wird. Unter "Sicherstellen" wird insbesondere auch das Überwachen, Einstellen und/oder Anpassen der Druckkraft (ggf. auch während des Betriebes) verstanden.

Gemäß einer vorteilhaften Ausgestaltung des Verfahrens wird die erste Druckspannung quer zur Hauptwärmestromrichtung durch eine äußere Regelung der mindestens einen Druckkraft beeinflusst. Diese äußere Regelung kann z. B. durch eine Verspannungsvorrichtung realisiert werden, durch die eine regelbare mechanische und/oder eine hydraulische Druckkraft erzeugt werden kann.

Gemäß einer vorteilhaften Weiterbildung wird die erste Druckspannung selbstregulierend verändert. Dies kann insbesondere durch eine entsprechende Auslegung der Materialeigenschaften von thermoelektrischem Material und Füllmaterial gewährleistet werden. "Selbstregulierend" bedeutet hier insbesondere, dass keine aktive, externe Regulierung der Druckspannung erfolgt, sondern insbesondere dass die Konstruktion so ausgelegt ist, dass sich das vorgegebenen Druckspannungsverhältnis während des Betriebes des thermoelektrischen Moduls in unterschiedlichen Temperaturbereichen automatisch bzw. passiv anpasst. In besonders vorteilhafter Weise werden äußere Regelungen und selbstregulierende Maßnahmen miteinander kombiniert.

Weiterhin wird ein thermoelektrischer Generator vorgeschlagen, der zumindest zwei erfindungsgemäße thermoelektrische Module aufweist, wobei die thermoelektrischen Module durch eine (insbesondere einzige) Komponente des thermoelektrischen Generators gemeinsam mit zumindest einer Druckkraft zur Erzeugung einer ersten Druckspannung beaufschlagt werden. In besonders vorteilhafter Weise wird also nicht jedes einzelne thermoelektrische Modul eines thermoelektrischen Generators mit einer jeweils einzeln erzeugten Druckkraft beaufschlagt, sondern es ist z. B. eine gemeinsame Verspannungsvorrichtung konstruktiv so ausgelegt, dass mehrere thermoelektrische Module entsprechend gleichzeitig beaufschlagt werden können. Insbesondere können mehrere thermoelektrische Module entsprechend auch hintereinander angeordnet werden, so dass die Druckkraft auch zwischen den thermoelektrischen Modulen übertragen wird.

Weiterhin wird ein Kraftfahrzeug vorgeschlagen, zumindest aufweisend ein erfindungsgemäßes thermoelektrisches Modul oder einen erfindungsgemäßen thermoelektrischen Generator. Dabei können dieses Modul und/oder dieser Generator auch zum Betrieb mit dem erfindungsgemäß beschriebenen Verfahren eingerichtet sein.

Die Erfindung sowie das technische Umfeld werden nachfolgend anhand der Figuren näher erläutert. Die Figuren zeigen besonders bevorzugte Ausführungsbeispiele, auf die die Erfindung jedoch nicht begrenzt ist. Es zeigen schematisch:
- Fig. 1:: ein thermoelektrisches Modul in einer Seitenansicht,
- Fig. 2:: einen Ausschnitt des thermoelektrischen Moduls aus Fig. 1,
- Fig. 3:: ein rohrförmiges thermoelektrisches Modul,
- Fig. 4:: einen Verlauf der Druckspannung,
- Fig. 5:: einen thermoelektrischen Generator, und
- Fig. 6:: ein Kraftfahrzeug.

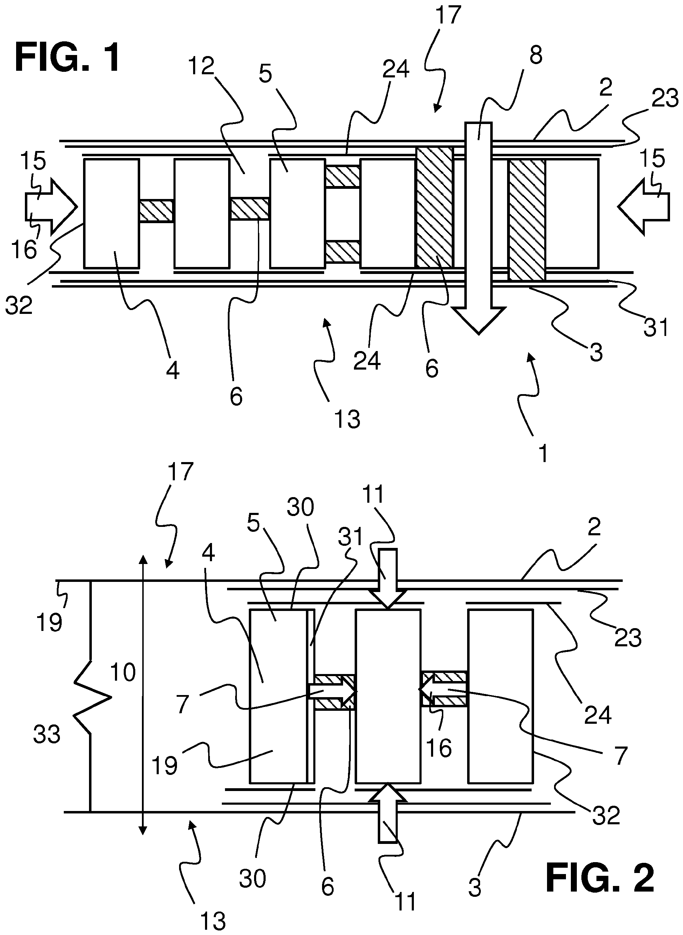

Fig. 1 zeigt in einer Seitenansicht ein thermoelektrisches Modul 1, dessen Außenseiten durch eine erste Wandung 2 und eine zweite Wandung 3 gebildet werden. Die erste Wandung 2 und zweite Wandung 3 umgeben einen Zwischenraum 12, in dem Elemente 4 aus thermoelektrischem Material 5 und weitere Komponenten 19 (Isolierungen 23, Verbindungen 24, Verbindungsschichten 31, Elemente 4, usw.) des thermoelektrischen Moduls 1 angeordnet sind. Die erste Wandung 2 ist einer Heißseite 17 zugeordnet und entsprechend die gegenüberliegend angeordnete zweite Wandung 3 einer Kaltseite 13. An der ersten Wandung 2 und an der zweiten Wandung 3 sind jeweils Isolierungen 23 als Verbindungsschicht 31 zwischen erster Wandung 2 und thermoelektrischen Materialien 5 angeordnet. Die benachbart zueinander angeordneten Elemente 4 aus thermoelektrischen Materialien 5 sind jeweils wechselweise elektrisch leitend über Verbindungen 24 (Leiterbahnen, Kabel, etc.) miteinander verbunden.

Die thermoelektrischen Materialien 5 sind durch Füllmaterialien 6 voneinander beabstandet. Hier sind unterschiedliche Ausführungsbeispiele von Füllmaterialien 6 gezeigt. Dabei erstreckt sich das Füllmaterial 6 nicht über die vollständige Seitenfläche 32 des thermoelektrischen Materials 5, sondern beaufschlagt nur einen Teilbereich der Seitenfläche 32. Ggf. sind auch mehrere Füllmaterialien 6 zwischen benachbart zueinander angeordneten Elementen 4 vorgesehen. Es sind zudem Füllmaterialien 6 gezeigt, die sich über die gesamte Seitenfläche 32 des thermoelektrischen Materials 5 und zudem über die Verbindung 24 hinaus, bis zur Isolierung 23 an der ersten Wandung 2 oder zweiten Wandung 3 hin, erstrecken.

Zwischen der Heißseite 17 und der Kaltseite 13 bildet sich ein Temperaturpotential aus, so dass ein Wärmestrom in Hauptwärmestromrichtung 8 von der Heißseite 17 hin zur Kaltseite 13 bevorzugt durch die thermoelektrischen Materialien 5 fließt. Durch diesen Wärmestrom erzeugen die thermoelektrischen Materialien 5 infolge des Seebeck-Effekts einen elektrischen Strom, der über die Verbindungen 24 an entsprechende Stromabnehmer (Batterie, elektrische Verbraucher, etc.) außerhalb des thermoelektrischen Moduls 1 abgeführt wird. Auf die Elemente 4 wirkt in einer Richtung 16 quer zur Hauptwärmestromrichtung 8 eine Druckkraft 15 von außen auf das thermoelektrische Modul 1.

Fig. 2 zeigt einen Ausschnitt aus der Fig. 1, wobei hier Elemente 4 aus thermoelektrischem Material 5 vergrößert dargestellt sind. Zwischen der Heißseite 17 und der Kaltseite 13 bildet sich ein Temperaturpotential 10 aus, das wiederum einen Wärmestrom zwischen Heißseite 17 und Kaltseite 13 durch die thermoelektrischen Materialien 5 hindurch erzeugt. Die thermoelektrischen Materialien 5 sind durch Verbindungen 24 elektrisch leitend wechselweise miteinander verbunden und durch eine Isolierung 23 von der ersten Wandung 2 bzw. von der zweiten Wandung 3 getrennt.

Die in Fig. 1 gezeigte Druckkraft 15 erzeugt über das zwischen den thermoelektrischen Materialien 5 angeordnete Füllmaterial 6 eine erste Druckspannung 7, die in einer Richtung 16 quer zur Hauptwärmestromrichtung 8 auf die thermoelektrischen Materialien 5 einwirkt. Infolge der thermischen Beanspruchung werden die thermoelektrischen Materialien 5 in einer Richtung parallel zur Hauptwärmestromrichtung 8 durch eine zweite Druckspannung 11 beaufschlagt, die eine Ausdehnung durch Querkontraktion und/ oder ein Kriechen des thermoelektrischen Materials 5 in einer Richtung 16 quer zur Hauptwärmestromrichtung 8 hervorruft. Die Füllmaterialien 6 sind auf der Seitenfläche 32 des thermoelektrischen Materials 5 angeordnet. Durch die erste Druckspannung 7 wird eine Ausdehnung infolge der Querkontraktion und/ oder ein Kriechen des thermoelektrischen Materials 5 in eine Richtung 16 quer zur Hauptwärmestromrichtung 8 vermieden.

In Fig. 2 ist weiterhin gezeigt, dass die zweite Druckspannung 11 durch ein Dehnelement 33 in der ersten Wandung 2 und/oder in der zweiten Wandung 3 und/oder zwischen der ersten und der zweiten Wandung 2, 3 verringert werden kann.

Gezeigt ist hier weiterhin, dass die Seitenflächen 32 der thermoelektrischen Materialien 5 weitere Verbindungsschichten 31 aufweisen können, hier z. B. eine elektrische Isolierung. Weiterhin ist hier gezeigt, dass die thermoelektrischen Materialien 5 zwei gegenüberliegende Seiten 30 aufweisen, die einerseits über Verbindungen 24 bzw. Isolierungen 23 mit der ersten Wandung 2 und der zweiten Wandung 3 wärmeleitend verbunden sind.

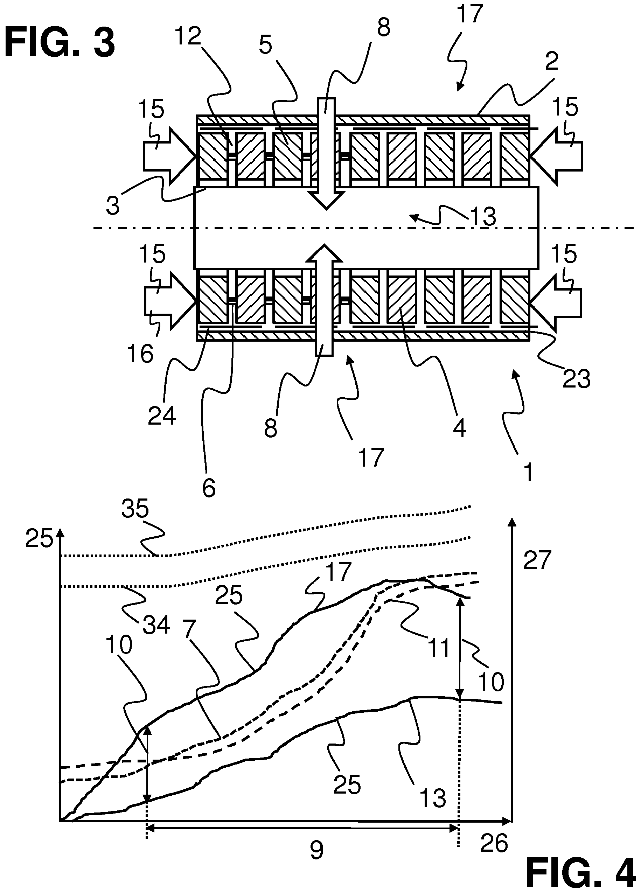

Fig. 3 zeigt ein rohrförmiges thermoelektrisches Modul 1 mit einer ersten Wandung 2 und einer zweiten Wandung 3. Die zweite Wandung 3 bildet hier einen inneren Kanal des rohrförmigen thermoelektrischen Moduls 1, der hier als Kaltseite 13 ausgeführt ist und somit beispielsweise für Kühlwasser durchströmbar ist. Die Außenumfangsfläche des thermoelektrischen Moduls 1, die durch die zweite Wandung 2 gebildet wird, ist als Heißseite 17 ausgeführt und kann z. B. von einem heißen Abgas beströmt werden. Ausgehend von der Heißseite 17 wird ein Wärmestrom in Richtung der Hauptwärmestromrichtung 8 hin zur Kaltseite 13 erzeugt. Dadurch kommt es zu einer Ausdehnung der thermoelektrischen Materialien 5 in einer Richtung parallel zur Hauptwärmestromrichtung 8 und entsprechend zu einer zweiten Druckspannung 11. Diese zweite Druckspannung 11 wird hervorgerufen durch die unterschiedliche Ausdehnung der einzelnen Komponenten 19 des thermoelektrischen Moduls 1, z.B. der thermoelektrischen Materialien 5 und der ersten Wandung 2 und zweiten Wandung 3. Diese zweite Druckspannung 11 wird nun durch Aufbringung einer Druckkraft 15, die eine erste Druckspannung 7 zwischen den thermoelektrischen Materialien 5 hervorruft insoweit ausgeglichen, dass eine Ausdehnung infolge Querkontraktion und/ oder ein Kriechen/ eine plastische Verformung der thermoelektrischen Materialien 5 in einer Richtung 16 quer zur Hauptwärmestromrichtung 8 nicht erfolgt.

Weiterhin sind hier Zwischenräume 12 zwischen den thermoelektrischen Materialien 5 gezeigt, in denen Füllmaterialien 6 angeordnet sind und durch die die benachbart zueinander angeordneten thermoelektrischen Elemente 4 voneinander beabstandet sind. Weiterhin sind Isolierungen 23 und Verbindungen 24 jeweils an der ersten Wandung 2 und an der zweiten Wandung 3 vorgesehen.

Fig. 4 zeigt illustrativ den Verlauf von Druckspannungen in einem Betriebsbereich des thermoelektrischen Moduls 1. An der linken senkrechten Achse ist die Temperatur 25 aufgetragen, an der rechten senkrechten Achse der Betrag der Druckspannung 27. Die horizontale Achse beschreibt die Betriebszeit 26. Es ist erkennbar, dass mit Fortschreiten der Betriebszeit 26 die Temperatur 25 an der Heißseite 17 ansteigt bzw. einen spezifischen Verlauf annimmt. Entsprechend steigt durch den Hauptwärmestrom auch die Temperatur 25 an der Kaltseite 13 des thermoelektrischen Moduls 1. In einem an der horizontalen Achse gezeigten Betriebsbereich 9 bildet sich ein Temperaturpotential 10 aus. In diesem Betriebsbereich 9 ist eine zweite Druckspannung 11, die an den thermoelektrischen Materialien 5 in einer Richtung parallel zur Hauptwärmestromrichtung 8 anliegt, kleiner als eine erste Druckspannung 7, die die thermoelektrischen Materialien 5 in einer Richtung 16 quer zur Hauptwärmestromrichtung 8 beaufschlagt. Die Neigung der Elemente 4 zur Ausdehnung infolge Querkontraktion (bei Überschreitung der ersten Grenzspannung 34) oder infolge plastischer Verformung (bei Überschreitung der zweiten Grenzspannung 35) in einer Richtung quer zur Hauptwärmestromrichtung 8 wird durch die Beaufschlagung der Elemente 4 mit der zweiten Druckspannung 11 verringert oder verhindert. Durch diese "Einspannung" der thermoelektrischen Elemente 4 wird insbesondere verhindert, dass die erste Grenzspannung 34 und/oder die zweite Grenzspannung 35 des thermoelektrischen Materials überschritten werden.

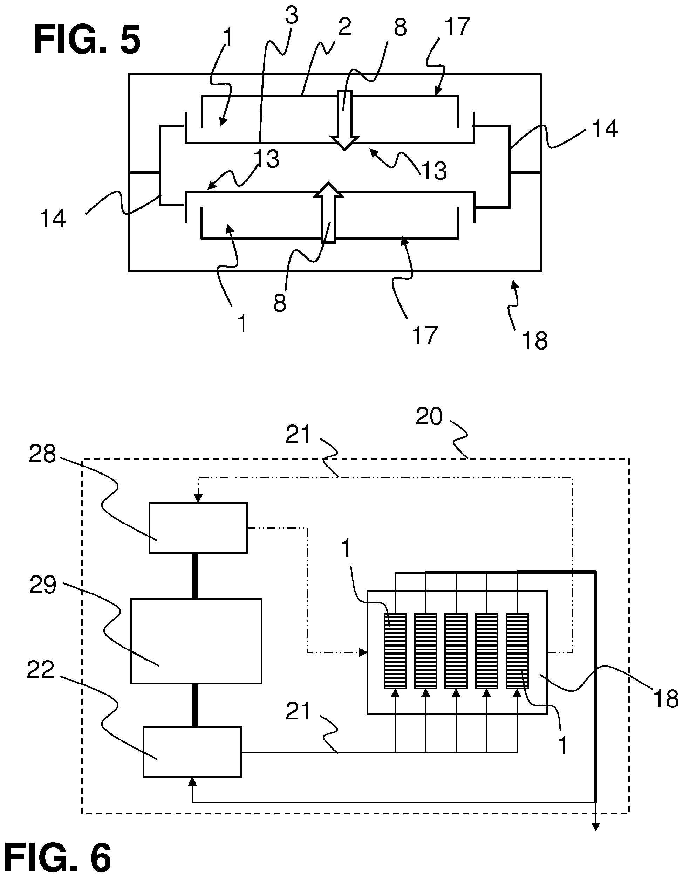

Fig. 5 zeigt einen thermoelektrischen Generator 18 mit zwei thermoelektrischen Modulen 1. Diese weisen jeweils eine Heißseite 17 und eine Kaltseite 13 auf, zwischen denen sich in einer Hauptwärmestromrichtung 8 ein Wärmestrom ausbildet. Die thermoelektrischen Module 1 weisen an ihrer jeweiligen Kaltseite 13 bzw. an ihrer, die Kaltseite 13 bildenden, zweiten Wandung 3 eine Verspannungsvorrichtung 14 auf. Diese Verspannungsvorrichtung 14 stützt sich am thermoelektrischen Generator 18 bzw. an dessen Gehäuse ab und wirkt gleichermaßen auf die jeweilige Kaltseite 13 der beiden thermoelektrischen Module 1.

Fig. 6 zeigt ein Kraftfahrzeug 20 mit einer Verbrennungskraftmaschine 29, einer Kühlung 28 und einer Abgasanlage 22. Ein kaltes Medium 21 durchströmt, ausgehend von der Kühlung 28, thermoelektrische Module 1, die innerhalb eines thermoelektrischen Generators 18 angeordnet sind. Weiterhin durchströmt ein heißes Medium 21 ausgehend von der Verbrennungskraftmaschine bzw. von der Abgasanlage 22 die thermoelektrischen Module 1. Durch die Beaufschlagung der thermoelektrischen Module 1 mit einem Abgas als heißes Medium 21 und einer Kühlflüssigkeit als kaltes Medium 21 bildet sich ein Temperaturpotential an diesen aus, so dass ein elektrischer Strom im thermoelektrischen Generator 18 erzeugt werden kann.

### Bezugszeichenliste

- 1: Thermoelektrisches Modul
- 2: Erste Wandung
- 3: Zweite Wandung
- 4: Elemente
- 5: Thermoelektrisches Material
- 6: Füllmaterial
- 7: Erste Druckspannung
- 8: Hauptwärmestromrichtung
- 9: Betriebsbereich
- 10: Temperaturpotential
- 11: Zweite Druckspannung
- 12: Zwischenraum
- 13: Kaltseite
- 14: Verspannungsvorrichtung
- 15: Druckkraft
- 16: Richtung
- 17: Heißseite
- 18: Thermoelektrischer Generator
- 19: Komponente
- 20: Kraftfahrzeug
- 21: Medium
- 22: Abgasanlage
- 23: Isolierung
- 24: Verbindung
- 25: Temperatur
- 26: Betriebszeit
- 27: Druckspannung
- 28: Kühlung
- 29: Verbrennungskraftmaschine
- 30: Seite
- 31: Verbindungsschicht
- 32: Seitenfläche
- 33: Dehnelement
- 34: Erste Grenzspannung
- 35: Zweite Grenzspannung

## Patentansprüche

1. Thermoelektrisches Modul (1), zumindest aufweisend eine erste Wandung (2) und eine gegenüberliegend angeordnete zweite Wandung (3) sowie dazwischen angeordnete Elemente (4) aus thermoelektrischem Material (5), die elektrisch leitend miteinander verbunden sind, sowie ein Füllmaterial (6), durch das alle Elemente (4) voneinander beabstandet sind, und eine Hauptwärmestromrichtung (8), die von einer, durch die ersten Wandung (2) gebildeten Heißseite (17) hin zur zweiten Wandung (3) verläuft, **dadurch gekennzeichnet, dass** im Betrieb des thermoelektrischen Moduls (1), zumindest in einem Temperaturbereich zwischen 50 und 600 °C an der Heißseite, eine auf die Elemente (4) in Hauptwärmestromrichtung (8) einwirkende zweite Druckspannung (11) zumindest eine erste Grenzspannung (34) nicht überschreitet, wobei bei Überschreitung der ersten Grenzspannung (34) eine Querkontraktion des eingesetzten thermoelektrischen Materials (5) einsetzt,
oder zumindest eine zweite Grenzspannung (35) nicht überschreitet, wobei bei Überschreitung der zweiten Grenzspannung (35) eine plastische Verformung des eingesetzten thermoelektrischen Materials (5) einsetzt.

2. Thermoelektrisches Modul (1), zumindest aufweisend eine erste Wandung (2) und eine gegenüberliegend angeordnete zweite Wandung (3) sowie dazwischen angeordnete Elemente (4) aus thermoelektrischem Material (5), die elektrisch leitend miteinander verbunden sind, sowie ein Füllmaterial (6), durch das alle Elemente (4) voneinander beabstandet sind, und eine Hauptwärmestromrichtung (8), die von der ersten Wandung (2) hin zur zweiten Wandung (3) verläuft, **dadurch gekennzeichnet, dass** das thermoelektrische Modul (1) derart durch zumindest eine Druckkraft (15) verspannt ist, dass eine erste Druckspannung (7) quer zur Hauptwärmestromrichtung (8), zumindest in einem Bereich (9), in dem ein Temperaturpotential (10) zwischen erster Wandung (2) und zweiter Wandung (3) mindestens 50 Kelvin beträgt, mindestens 50 % einer zweiten Druckspannung (11) in Hauptwärmestromrichtung (8) beträgt.

3. Thermoelektrisches Modul (1) nach Patentanspruch 1, wobei das Füllmaterial (6) zumindest in einem Temperaturbereich von 50 bis 600 °C einen größeren thermischen Ausdehnungskoeffizienten aufweist als das thermoelektrische Material (5).

4. Thermoelektrisches Modul (1) nach Patentanspruch 1, wobei das Füllmaterial (6) zumindest in einem Temperaturbereich von 50 bis 600 °C eine geringere Wärmeleitfähigkeit [Watt / (Meter * Kelvin] aufweist als das thermoelektrische Material (5).

5. Thermoelektrisches Modul (1) nach einem der vorhergehenden Patentansprüche, wobei das Füllmaterial (5), betrachtet zumindest in einer Richtung (16) parallel zur Hauptwärmestromrichtung (8), einen Zwischenraum (12) zwischen erster Wandung (2) und zweiter Wandung (3) nicht vollständig ausfüllt.

6. Thermoelektrisches Modul (1) nach einem der vorhergehenden Patentansprüche, wobei auf einer Kaltseite (13) eine Verspannungsvorrichtung (14) zur Erzeugung einer Druckkraft (15) auf das thermoelektrische Modul (1) in einer Richtung (16) quer zur Hauptwärmestromrichtung (8) angeordnet ist.

7. Verfahren zum Betrieb eines thermoelektrisches Moduls (1), wobei das thermoelektrische Modul (1) eine erste Wandung (2) und eine zweite Wandung (3) und dazwischen angeordnet Elemente (4) aus thermoelektrischem Material (5) aufweist, die elektrisch leitend miteinander verbunden sind, und im Betrieb ein Temperaturpotential (10) zwischen erster Wandung (2) und zweiter Wandung (3) vorliegt und eine Hauptwärmestromrichtung (8) von der ersten Wandung (2) hin zur zweiten Wandung (3) verläuft; wobei das Verfahren zum Betrieb zumindest folgende Schritte aufweist:
a) Erzeugen eines Temperaturpotentials zwischen erster Wandung (2) und zweiter Wandung (3);
b) Aufbringen mindestens einer Druckkraft (15) zur Erzeugung einer ersten Druckspannung (7) quer zur Hauptwärmestromrichtung (8), wobei die Druckspannung zumindest auf eine Mehrheit der Elemente (4) einwirkt; weiterhin **gekennzeichnet durch**
c) Sicherstellen, dass zumindest in einem Bereich (9), in dem ein Temperaturpotential (10) zwischen erster Wandung (2) und zweiter Wandung (3) mindestens 50 Kelvin beträgt, die erste Druckspannung (7) mindestens 50 % einer zweiten Druckspannung (11) in Hauptwärmestromrichtung (8) beträgt.

8. Verfahren nach Patentanspruch 7, wobei die erste Druckspannung (7) quer zur Hauptwärmestromrichtung (8) durch eine äußere Regelung der mindestens einen Druckkraft (15) beeinflusst wird.

9. Verfahren nach Patentanspruch 7, wobei die erste Druckspannung (7) selbstregulierend verändert wird.

10. Thermoelektrischer Generator (18) zumindest aufweisend zwei thermoelektrische Module (1) gemäß einem der Patentansprüche 1 bis 6, wobei die thermoelektrischen Module (1) durch eine Komponente (19) des thermoelektrischen Generators (18) gemeinsam mit zumindest einer Druckkraft (15) zur Erzeugung einer ersten Druckspannung (7) beaufschlagt werden.

11. Kraftfahrzeug (20), zumindest aufweisend ein thermoelektrisches Modul (1) nach einem der Patentansprüche 1 bis 6 oder zumindest aufweisend einen thermoelektrischen Generator (18) gemäß Patentanspruch 10.

## Claims

1. Thermoelectric module (1), at least having a first wall (2) and an oppositely arranged second wall (3) and interposed elements (4) composed of thermoelectric material (5), which elements are connected to one another in electrically conductive fashion, and a filler material (6) by means of which all of the elements (4) are spaced apart from one another, and a main heat flow direction (8) which runs from a hot side (17), formed by the first wall (2), to the second wall (3), **characterized in that**, during operation of the thermoelectric module (1), at least in a temperature range between 50 and 600°C at the hot side, a second compressive stress (11) acting on the elements (4) in the main heat flow direction (8) does not exceed at least a first threshold stress (34), wherein a transverse contraction of the thermoelectric material (5) that is used commences in the event of exceedance of the first threshold stress (34),
or does not exceed at least a second threshold stress (35), wherein a plastic deformation of the thermoelectric material (5) that is used commences in the event of exceedance of the second threshold stress (35).

2. Thermoelectric module (1), at least having a first wall (2) and an oppositely arranged second wall (3) and interposed elements (4) composed of thermoelectric material (5), which elements are connected to one another in electrically conductive fashion, and a filler material (6) by means of which all of the elements (4) are spaced apart from one another, and a main heat flow direction (8) which runs from the first wall (2) to the second wall (3), **characterized in that** the thermoelectric module (1) is braced by means of at least one compressive force (15) such that, at least in a range (9) in which a temperature potential (10) between first wall (2) and second wall (3) is at least 50 kelvin, a first compressive stress (7) perpendicular to the main heat flow direction (8) is at least 50% of a second compressive stress (11) in the main heat flow direction (8).

3. Thermoelectric module (1) according to Patent Claim 1, wherein, at least in a temperature range from 50 to 600°C, the filler material (6) has a greater coefficient of thermal expansion than the thermoelectric material (5).

4. Thermoelectric module (1) according to Patent Claim 1, wherein, at least in a temperature range from 50 to 600°C, the filler material (6) exhibits lower thermal conductivity [watt / (meter * kelvin)] than the thermoelectric material (5).

5. Thermoelectric module (1) according to one of the preceding patent claims, wherein, viewed at least in a direction (16) parallel to the main heat flow direction (8), the filler material (5) does not completely fill an intermediate space (12) between first wall (2) and second wall (3).

6. Thermoelectric module (1) according to one of the preceding patent claims, wherein a bracing device (14) for generating a compressive force (15) on the thermoelectric module (1) in a direction (16) perpendicular to the main heat flow direction (8) is arranged on a cold side (13).

7. Method for operation of a thermoelectric module (1), wherein the thermoelectric module (1) has a first wall (2) and a second wall (3) and interposed elements (4) composed of thermoelectric material (5), which elements are connected to one another in electrically conductive fashion, and during operation, a temperature potential (10) prevails between first wall (2) and second wall (3) and a main heat flow direction (8) runs from the first wall (2) to the second wall (3); wherein the method for operation has at least the following steps:
a) generating a temperature potential between first wall (2) and second wall (3);
b) applying at least one compressive force (15) for the generation of a first compressive stress (7) perpendicular to the main heat flow direction (8), wherein the compressive stress acts at least on a majority of the elements (4);
furthermore **characterized by**
c) ensuring that, at least in a range (9) in which a temperature potential (10) between first wall (2) and second wall (3) is at least 50 kelvin, the first compressive stress (7) is at least 50% of a second compressive stress (11) in the main heat flow direction (8).

8. Method according to Patent Claim 7, wherein the first compressive stress (7) perpendicular to the main heat flow direction (8) is influenced by way of external regulation of the at least one compressive force (15).

9. Method according to Patent Claim 7, wherein the first compressive stress (7) is varied in self-regulating fashion.

10. Thermoelectric generator (18) at least having two thermoelectric modules (1) according to one of Patent Claims 1 to 6, wherein the thermoelectric modules (1) are acted on, by a component (19) of the thermoelectric generator (18), jointly with at least one compressive force (15) for the generation of a first compressive stress (7).

11. Motor vehicle (20), at least having a thermoelectric module (1) according to one of Patent Claims 1 to 6 or at least having a thermoelectric generator (18) according to Patent Claim 10.

## Revendications

1. Module thermoélectrique (1) présentant
au moins une première paroi (2) et une deuxième paroi (3) située face à la première ainsi que des éléments (4) en matériau thermoélectrique (5) disposés entre ces parois et reliés les uns aux autres de manière électriquement conductrice, et
un matériau de charge (6) par lequel tous les éléments (4) sont maintenus à distance mutuelle,
et une direction principale (8) d'écoulement de chaleur qui s'étend depuis un côté de chauffage (17) formé par la première paroi (2) jusqu'à la deuxième paroi (3),
**caractérisé en ce que**
lorsque le module thermoélectrique (1) est en fonctionnement, au moins dans une plage de température comprise entre 50 et 600°C sur le côté chaud, une deuxième contrainte de compression (11) qui agit sur les éléments (4) dans la direction principale (8) d'écoulement de chaleur ne dépasse pas au moins une première contrainte limite (34),
**en ce que** lorsque la première contrainte limite (34) est dépassée, une contraction transversale du matériau thermoélectrique (5) inséré s'établit ou
ne dépasse pas au moins une deuxième contrainte limite (35) et
**en ce qu'**une déformation plastique du matériau thermoélectrique (5) utilisé s'établit lorsque la deuxième contrainte limite (35) est dépassée.

2. Module thermoélectrique (1) présentant
au moins une première paroi (2) et une deuxième paroi (3) située face à la première ainsi que des éléments (4) en matériau thermoélectrique (5) disposés entre ces parois et reliés les uns aux autres de manière électriquement conductrice, et
un matériau de charge (6) par lequel tous les éléments (4) sont maintenus à distance mutuelle,
et une direction principale (8) d'écoulement de chaleur qui s'étend depuis la première paroi (2) jusqu'à la deuxième paroi (3),
**caractérisé en ce que**
le module thermoélectrique (1) est précontraint par au moins une force de compression (15) de telle sorte qu'au moins dans une partie (9) dans laquelle le potentiel de température (10) entre la première paroi (2) et la deuxième paroi (3) vaut au moins 50 Kelvin, une première contrainte de compression (7) dans la direction transversale par rapport à la direction principale (8) d'écoulement de chaleur représente au moins 50 % d'une deuxième contrainte de compression (11) dans la direction principale (8) d'écoulement de chaleur.

3. Module thermoélectrique (1) selon la revendication 1, dans lequel au moins dans une plage de température allant de 50 à 600°C, le matériau de filtre (6) présente un coefficient de dilatation thermique plus grand que celui du matériau thermoélectrique (5).

4. Module thermoélectrique (1) selon la revendication 1, dans lequel au moins dans une plage de température allant de 50 à 600°C, le matériau de filtre (6) présente une conductivité thermique (Watt/(mètre*Kelvin)) plus basse que le matériau thermoélectrique (5).

5. Module thermoélectrique (1) selon l'une des revendications précédentes, dans lequel le matériau de charge (5) vu au moins dans une direction (16) parallèle à la direction principale (8) d'écoulement de chaleur ne remplit pas complètement l'espace intermédiaire (12) situé entre la première paroi (2) et la deuxième paroi (3).

6. Module thermoélectrique (1) selon l'une des revendications précédentes, dans lequel sur le côté froid (13), un ensemble (14) de contrainte qui exerce une force de poussée (15) sur le module thermoélectrique (1) dans une direction (16) transversale par rapport à la direction principale (8) d'écoulement de chaleur est disposé.

7. Procédé d'utilisation d'un module thermoélectrique (1), le module thermoélectrique (1) présentant :
au moins une première paroi (2) et une deuxième paroi (3) ainsi que des éléments (4) en matériau thermoélectrique (5) disposés entre ces parois et reliés les uns aux autres de manière électriquement conductrice,
un potentiel de température (10) s'établissant rn fonctionnement entre la première paroi (2) et la deuxième paroi (3) et
une direction principale (8) d'écoulement de chaleur s'étendant la première paroi (2) jusqu'à la deuxième paroi (3),
le procédé de conduite présentant au moins les étapes suivantes :
a) formation d'un potentiel de température entre la première paroi (2) et la deuxième paroi (3),
b) application d'au moins une force de poussée (15) en vue de forme une première contrainte de compression (7) transversale par rapport à la direction principale (8) d'écoulement de chaleur, la contrainte de compression agissant au moins sur une majorité des éléments (4),
le procédé étant en outre **caractérisé par** l'étape qui consiste à
c) assurer qu'au moins dans une partie (9) dans laquelle un potentiel de température (10) entre la première paroi (2) et la deuxième paroi (3) est d'au moins 50 Kelvin, la première contrainte de compression (7) représente au moins 50 % d'une deuxième contrainte de compression (11) dans la direction principale (8) d'écoulement de chaleur.

8. Procédé selon la revendication 7, dans lequel la première contrainte de compression (7) est influencée dans la direction transversale à la direction principale (8) d'écoulement de chaleur par une régulation externe de la ou des forces de poussée (15).

9. Procédé selon la revendication 7, dans lequel la première contrainte de compression (7) est modifiée en étant auto-régulée.

10. Générateur thermoélectrique (18) présentant au moins deux modules thermoélectriques (1) selon l'une des revendications 1 à 6, dans lequel au moins une force de poussée (15) destinée à produire une première contrainte de compression (7) est appliquée par un composant (19) du générateur thermoélectrique (18) conjointement sur les modules thermoélectriques (1).

11. Véhicule automobile (20) présentant au moins un module thermoélectrique (1) selon l'une des revendications 1 à 6 ou présentant au moins un générateur thermoélectrique (18) selon la revendication 10.
